# EUROPEAN PATENT APPLICATION

(11) **EP 3 845 356 A1**
(43) Date of publication of application: **07.07.2021**
(21) Application number: 19855521.1
(22) Date of filing: 30.08.2019
(51) Int. Cl.: B29C 33/44, B29C 33/42, B29C 51/30

(54) **MOLDING DIE AND LENS**

(30) Priority: 31.08.2018 JP 2018164044
(71) Applicant: Tohoku Techno Arch Co., Ltd., Sendai-shi, Miyagi 980-0845 (JP); Nagase & Co., Ltd., Osaka 550-8668 (JP)
(72) Inventor: SAMUKAWA,Seiji, Miyagi 980-8577 (JP); OHORI, Daisuke, Miyagi 980-8577 (JP)
(74) Representative: Winter, Brandl - Partnerschaft mbB
(86) International application number: PCT/JP2019/034281
(87) International publication number: WO 2020/045668

(57) **Abstract**

An object of the present invention is to provide a molding die that does not require the provision of a release agent layer on the surface thereof. Another object of the present invention is to provide a lens that has excellent durability and has a surface with water repellency.

The present invention relates to a molding die comprising a base portion and a pattern portion having recesses and protrusions provided on a surface of the base portion, wherein a distance between the centers of protruding portions of the pattern portion is 15 to 50 nm, a ratio of recessed and protruding portion (protrusion/distance between centers of the protruding portions) of the pattern portion is 0.5 or less, a height of the protruding portion of the pattern portion is 2 nm or more, and a defect density of the pattern portion is 10 × 10¹⁰ cm² or less. The present invention also relates to a lens comprising a base portion and a pattern portion having recesses and protrusions provided on a surface of the base portion, wherein a distance between centers of protruding portions of the pattern portion is 15 to 50 nm.

## Description

### Technical Field

The present invention relates to a molding die and a lens.

### Background Art

As a technique for fine patterning, a mold with a pattern having recesses and protrusions opposite to the pattern desired to be formed on the substrate is prepared, and is pressed against a resist film layer formed on the surface of the target substrate to transfer a predetermined pattern. For example, in the nanoprinting method, which is a pattern transfer technique for forming structures with fine recessed and protruding shapes, there is a technique in which a Ni mold and a target substrate are released from each other without detachment by mechanical action (for example, Patent Literature 1).

The present inventors have researched and developed a neutral particle beam processing apparatus and have achieved an apparatus that allows for process pre-treatment, post-treatment, annealing, etc., such as removal of an oxide film formed on the surface of a substrate, removal of contaminants, and surface maintenance, by exciting a rare gas to generate a plasma and applying an electric field to the charged particles in this plasma to impart a predetermined energy, as well as neutralizing the charged particles to produce neutral particles and controlling the energy of the neutral particles (for example, Patent Literature 2). And, using this neutral particle beam processing apparatus, the present inventors have developed a semiconductor laser apparatus with highly uniform quantum nanodots (for example, Patent Literature 3).

By the way, for lenses, such as ocular lenses and photography lenses, giving water repellency to the surface thereof has been examined. As a method of imparting water repellency to the surface of lenses, providing a layer with water repellency by coating or the like on the surface of lenses has been examined, but there is a problem in durability, such as the water repellent layer peeling off from the surface after prolonged use.

### Citation List

### Patent Literature

Patent Literature 1: JP 2006-289519 A
Patent Literature 2: JP 2009-290026 A
Patent Literature 3: WO 2012/173162 A1

### Summary of Invention

### Technical Problem

In the technique disclosed in Patent Literature 1, a mold includes a metal mold substrate and an oxide film that is spontaneously formed on the outer surface thereof in the atmosphere, or otherwise that is formed adjusting the ambient temperature, and a release agent layer is formed on the surface of the oxide film of the mold, in which recessed and protruding shapes are formed. Therefore, it is necessary to form a release agent layer, and because nano-sized fine recesses and protrusions are provided, the production cost is high.

A first object of the present invention is to provide a molding die that does not require the provision of a release agent layer on the surface thereof and a method of manufacturing a molded article using the same.

A second object of the present invention is to provide a lens that has excellent durability and has a surface with water repellency.

### Solution to Problem

The object of the present invention can be solved by [1] to [10] of the following.
[1] A molding die comprising: a base portion; and a pattern portion having recesses and protrusions provided on a surface of the base portion, wherein a distance between the centers of protruding portions of the pattern portion is 15 to 50 nm, a ratio of a recessed and protruding portion (protrusion/distance between centers of the protruding portions) of the pattern portion is 0.5 or less, a height of the protruding portion of the pattern portion is 2 nm or more, and a defect density of the pattern portion is 10 × 10¹⁰ cm² or less;
[2] The molding die according to the above [1], wherein the surface of the pattern portion does not have a layer consisting of an oxide;
[3] The molding die according to the above [1] or [2], wherein the base portion and the pattern portion are composed of the same material;
[4] The molding die according to any one of the above [1] to [3], wherein a ratio of (height of the protruding portion) / (distance between centers of the protruding portions) of the pattern portion is 0.4 to 10;
[5] A method of manufacturing a molded article, comprising transferring the recesses and protrusions of the pattern portion, using the molding die according to any one of the above [1] to [4];
[6] A lens comprising: a base portion; and a pattern portion having recesses and protrusions provided on a surface of the base portion, wherein a distance between centers of protruding portions of the pattern portion is 15 to 50 nm;
[7] The lens according to the above [6], wherein the shortest distance between the protruding portions of the pattern portion is 5 nm;
[8] The lens according to the above [6] or [7], wherein a defect density of the pattern portion is 10 × 10¹⁰ cm² or less;
[9] The lens according to any one of the above [6] to [8], wherein the surface of the pattern portion does not have a layer consisting of an oxide;
[10] A method of manufacturing an article including a base portion and a pattern portion having recesses and protrusions provided on a surface of the base portion, the article having a distance between centers of protruding portions of the pattern portion of 15 to 50 nm, the method comprising: adsorbing uniformly a core-shell structure modified with a polymer onto a surface of the base portion or a surface of a layer provided on the base portion; removing a shell of the core-shell structure; and etching the base portion, using a core of the core-shell structure as a mask.

### Advantageous Effects of Invention

According to a first effect of the present invention, since the molding die includes a base portion and a pattern portion having recesses and protrusions provided on the surface of the base portion, in which the pattern portion has a distance between centers of protruding portions of 15 to 50 nm, the pattern portion has a ratio of recessed and protruding portion (protrusion/distance between centers of protruding portions) of 0.5 or less, and the pattern portion has a defect density of 10 × 10¹⁰ cm² or less, there is no need to provide a release agent layer on the surface of the molding die. In addition, by manufacturing a molded article using this molding die, the production cost can be reduced.

According to a second effect of the present invention, since the lens includes a base portion and a pattern portion having recesses and protrusions provided on the surface of the base portion, in which the pattern portion has a distance between centers of protruding portions of 15 to 50 nm, a lens that has excellent durability and has a surface with water repellency can be provided.

### Brief Description of Drawings

Figs. 1A and 1B are schematic drawings of a molding die or a lens according to the first embodiment of the present invention, and Fig. 1A is a cross-sectional view and Fig. 1B is a plan view.
Figs. 2A to 2F are schematic drawings illustrating a method of manufacturing the molding die shown in Figs. 1A and 1B.
Fig. 3 is a table summarizing the results for Examples, Comparative Examples, and Reference Examples.
Fig. 4 is a plan SEM image of a structure with silicon nanopillars made by the same procedure as in the Examples of the present invention.
Fig. 5 is a cross-sectional SEM image and TEM image of a silicon nanopillar structure.
Figs. 6A to 6D are schematic drawings illustrating a method of manufacturing the lens shown in Figs. 1A and 1B.
Fig. 7 is a figure showing the change in the transmittance of the lens manufactured in Example 10, according to the wavelength.

### Description of Embodiments

Hereinafter, with reference to the drawings, embodiments of the present invention will be described in detail. Embodiments of the present invention are not limited to the following, but also include those redesigned as appropriate within the scope of the present invention.

### First Embodiment

In the first embodiment, a molding die will be described. The molding die of the present invention includes a base portion and a pattern portion having recesses and protrusions provided on the surface of the base portion, and the pattern portion has a distance between centers of protruding portions of 15 to 50 nm, the pattern portion has a ratio of recessed and protruding portion (protrusion/distance between centers of protruding portions) of 0.5 or less, and the pattern portion has a defect density of 10 × 10¹⁰ cm² or less.

### (Molding die)

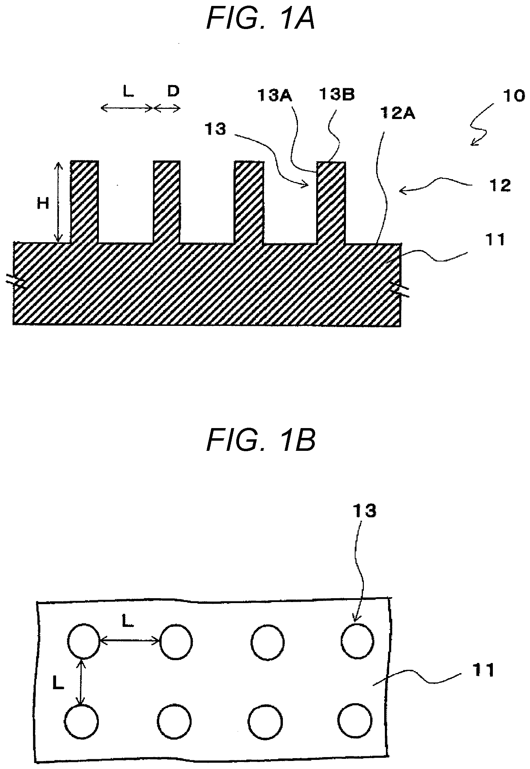

Figs. 1A and 1B are schematic drawings of a molding die according to the first embodiment of the present invention, and Fig. 1A is a cross-sectional view and Fig. 1B is a plan view. A molding die 10 according to the first embodiment of the present invention includes a base portion 11 and a pattern portion 12 having recesses and protrusions provided on the surface of the base portion 11. The pattern portion 12 is provided on a transfer surface side. Protruding portions in the pattern portion 12 are composed of pillars 13, for example.

It is preferable that the height H of the pillars 13 (that is, the height of the protruding portions) from the bottom surface 12A of the base portion 11 on the transfer surface side is 2 nm or more. When the height H of the pillars 13 is in this range, it is easier to release a molded article even without providing a release agent layer. The height H of the pillars 13 can be determined by, for example, analyzing a cross-sectional SEM image of the surface of the molding die.

The distance L between pillars 13 (the shortest distance between protruding portions, that is, the shortest distance between the end portion of one protruding portion and the end portion of another protruding portion closest to that protruding portion) is preferably 5 nm or more, more preferably 15 nm or more, and further preferably 30 nm or more. In addition, the distance L between pillars 13 is preferably 40 nm or less, and is more preferably 30 nm or less. When the distance L between pillars 13 is in this range, it is easier to release the molded article even without providing a release agent layer. The distance L between pillars 13 can be determined by analyzing a plan SEM image of the surface of the molding die.

The pillars 13 have a shape such as cylindrical, prismatic, and other shapes. When the pillars 13 are cylindrical, with respect to the diameter D of the bottom surface of the cylinders, the distance between centers of protruding portions in the pattern portion is 15 to 50 nm, and the ratio of recessed and protruding portion (protrusion/distance between centers of protruding portions) in the pattern portion is 0.5 or less. When the ratio of recessed and protruding portion is in this range, it is easier to release the molded article even without providing a release agent layer. The distance between centers of protruding portions can be determined by analyzing a plan SEM image of the surface of the molding die. The ratio of recessed and protruding portion in the pattern portion refers to a ratio of (average width of protruding portions) / (average distance between centers of protruding portions). The average value of the width of protruding portions and the average value of the distance between centers of protruding portions can be determined by analyzing a plan SEM image of the surface of the molding die.

The defect density in the pattern portion is preferably 10 × 10¹⁰ cm² or less, and is further preferably at or below the measurement limit and defect-free. When the defect density in the pattern portion is in this range, it is easier to release the molded article even without providing a release agent layer. Examples of making the defect density at or below 10 × 10¹⁰ cm² include a method of etching using a neutral particle beam apparatus. Measurement of the defect density is by the electron spin resonance method.

In the first embodiment of the present invention, since the recesses and protrusions on the transfer surface of the molding die 10 has low or no defects, the releasing treatment from the target material can be performed smoothly. Also, for the surface of the transferred material, a surface with low or no defects that is flat at the atomic layer level can be formed.

In the first embodiment of the present invention, although there includes an embodiment in which the side 13A and the surface 13B of the pillars 13, and the bottom surface 12A between adjacent pillars 13, constituting the recesses and protrusions of the pattern portion 12, have an oxide layer that occurs inevitably, it is preferable not to have an oxide layer. This is because the absence of an oxide layer allows for a smooth releasing treatment upon transfer. For example, the residual oxygen atoms can be removed from the surface by radical treatment with NF₃, hydrogen gas, and the like using a neutral particle beam apparatus, followed by annealing treatment. When the surface of the natural oxide film on the molding die has recesses and protrusions of several nm, the surface of the target material will also have recesses and protrusions of several nm. According to a preferable embodiment without an oxide layer, the pattern portion 12 is free of recesses and protrusions of several nm, the releasing treatment is performed smoothly, and a recessed and protruding surface of the molded article manufactured by the molding die 10 is formed by accurate transfer of the pattern portion 12. Therefore, corresponding to the water repellency of the pattern portion 12, the recessed and protruding surface of the molded article manufactured by the molding die 10 will have water repellency. Alternatively, corresponding to the hydrophilicity of the pattern portion 12, the recessed and protruding surface of the molded article manufactured by the molding die 10 will have hydrophilicity.

In the first embodiment of the present invention, the pattern portion 12 is preferably composed of the same material as the base portion 11. This is because the production process for the molding die 10 can be simplified and there is no need to prepare other materials.

In the first embodiment of the present invention, the degree of water repellency of the pattern portion 12 can be controlled by adjusting the distance L between pillars 13 in the pattern portion 12. In this way, corresponding to the water repellency of the pattern portion 12, the recessed and protruding surface of the molded article manufactured by the molding die 10 will have water repellency. Alternatively, corresponding to the hydrophilicity of the pattern portion 12, the recessed and protruding surface of the molded article manufactured by the molding die 10 will have hydrophilicity.

In the present specification, the water repellency on a solid surface is defined using the contact angle of a water droplet as an index. When the contact angle of a water droplet is 90 degrees or more and less than 110 degrees, the surface is defined to be water repellent. When the contact angle of a water droplet is 110 degrees or more and less than 150 degrees, the surface is defined to be highly water repellent. When the contact angle of a water droplet is 150 degrees or more, the surface is defined to be extremely water repellent. On the other hand, when the contact angle of a water droplet is 30 degrees or less, the surface is defined to be hydrophilic. When the contact angle of a water droplet is 10 degrees or less, the surface is defined to be super hydrophilic.

In the first embodiment of the present invention, by controlling at least one of the distance L between pillars 13, which are protruding portions in the pattern portion 12, and the height H, water repellency, and even high water repellency can be imparted. When the surface of the molding die 10 on the side that will be the transfer surface has water repellency, preferably high water repellency, the releasing treatment can be performed smoothly.

The ratio of (height H of pillars 13) / (distance L between pillars 13) is preferably 0.4 or more, and is more preferably 1 or more. The ratio of (height H of pillars 13)/(distance L between pillars 13) is preferably 10 or less, and is more preferably 5 or less. When the ratio of (height H of pillars 13)/(distance L between pillars 13) is in the range of 0.4 or more and 10 or less, the transfer surface of the molding die 10 becomes highly water repellent. Outside this range, the aspect ratio (height H/distance L) is large and the transfer surface becomes super hydrophilic due to capillarity.

In the first embodiment of the present invention, it is further preferable that the side 13A and the surface 13B of the pillars 13, and the bottom surface 12A between pillars 13, constituting the pattern portion 12, is flat at the atomic level. The surface area of the pillar 13 and the bottom surface 12A would change, and thus the degree of water repellency of the molding die 10 would change. The smaller the surface area of the pillar 13 and the bottom surface 12A, the better the water repellency is.

### (Method of manufacturing molding die)

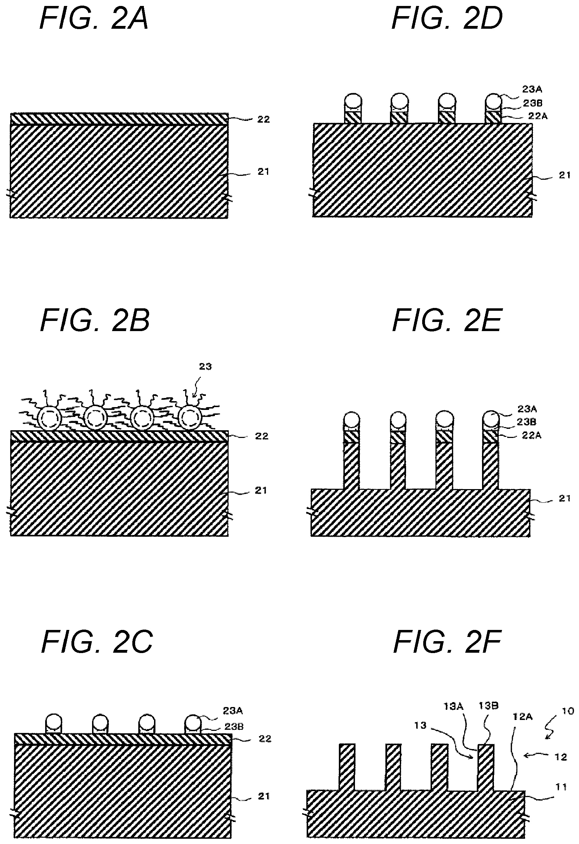

Figs. 2A to 2F are schematic drawings illustrating a method of manufacturing the molding die 10 shown in Figs. 1A and 1B. First, a substrate 21 is prepared. As the substrate 21, various semiconductor substrates such as Si semiconductor and compound semiconductor are preferable. The oxide film and impurities present on the surface of the substrate 21 are removed. The method of removal can be selected from various techniques conventionally known.

Next, as illustrated in Fig. 2A, a film 22 is formed on the substrate 21 on the transfer surface side so that no defects are generated on the surface of the substrate 21. In order to form the film 22, it is preferable to use a neutral particle beam processing apparatus (see Patent Literature 3). Examples of the film 22 include an oxide film or a nitride film. When obtaining an oxide film, it is preferable to irradiate the substrate with an oxygen neutral particle beam at an energy of 10 eV or more. When the substrate 21 is a Si substrate, SiO₂ is obtained as the oxide film. The thickness of the film 22 is preferably 1 nm or more.

Next, as illustrated in Fig. 2B, a core-shell structure 23 is uniformly adsorbed onto the film 22. Due to the hydrophobic interaction of the shell of the core-shell structure 23, the core-shell structure 23 can be uniformly adsorbed onto the film 22 on a plane parallel to the film 22. The core-shell structure 23 is a structure with a core of a compound such as a metal or an oxide thereof and a shell of a protein, and an example of the core-shell structure include ferritin.

As the core-shell structure 23, it is also possible to utilize a structure in which the outer circumference of a protein is modified with a polymer as a shell. Examples of the polymer include polyalkylene glycol such as polyethylene glycol and polypropylene glycol. By adjusting the molecular weight of the polymer (for example, adjusting the degree of polymerization of polyethylene glycol), the interval between cores can be controlled, and the distance between centers of protruding portions can be controlled. When the interval between cores is desired to be narrower, only ferritin is used as the core-shell structure without polymer modification.

Next, as illustrated in Fig. 2C, the polymer and the shell are removed by heat treatment or ozone treatment to expose the core metal or metal oxide. At this time, among the core-shell structure 23, a remaining portion 23B of the shell 23 may remain between the core 23A and the film 22. The temperature of the heat treatment is preferably 400°C or higher. The time of the heat treatment is preferably 5 minutes or longer. The time of the heat treatment is preferably 30 minutes or shorter.

Next, as illustrated in Fig. 2D, the film 22 is etched using the core 23A as a mask. When removing the oxide film, it is preferable to perform radical treatment with NF₃ and hydrogen gas using a radical treatment apparatus. By removing the oxide film, the substrate is exposed.

Subsequently, as illustrated in Fig. 2E, the surface of the substrate 21 is etched using the core 23A as a mask. By adjusting the depth of this etching, the height H of the pillars 13 can be controlled. For the etching of the substrate 21, it is preferable to use a neutral particle beam processing apparatus (Patent Literature 3). In the neutral particle beam processing apparatus, it is preferable to use, for example, chlorine gas as the etching gas and to irradiate the substrate with neutral particle beams at 10 eV or more and 100 eV or less. By irradiating the substrate 21 with neutral particle beams, it can be etched with low or no defects.

Then, the core 23A and a remaining portion 22A of the film 22 are removed. At this time, the remaining portion 23B of the shell 23 is also removed. Examples of the method of removing the core 23A include a method in which wet etching with a dilute hydrochloric acid solution is performed for 15 to 30 minutes. By removing the core 23A and the remaining portion 22A, a molding die can be obtained as in Fig. 2F.

At last, oxygen atoms are removed from the surface that will be the transfer surface by dilute hydrofluoric acid. Alternatively, it is preferable to perform radical treatment with NF₃ and hydrogen gas using a radical treatment apparatus. By going through a series of processes described above, the molding die 10 shown in Fig. 1 can be manufactured.

In the molding die 10 according to an embodiment of the present invention, the pattern portion 12 may be composed of the same material as the base portion 11 or may not be composed of the same material. An Example of the method to prevent the base portion 11 and the pattern portion 12 from being composed of the same material includes a method in which the thickness of the film 22 is made thicker than the pillars 13 and the pillars 13 are composed of the material of the film 22.

### (Method of manufacturing molded article)

A method of manufacturing a molded article according to the first embodiment of the present invention will be described. In an embodiment of the present invention, the molding die 10 shown in Fig. 1 is used. Here, examples of the molded article include a receiver or irradiator (antenna) for electromagnetic waves such as light waves and microwaves, a lens that transmits electromagnetic waves such as light waves and microwaves, and a window of traffic lights used in daily life through which LED light transmits. When the window portion for electromagnetic waves has water repellency, electromagnetic waves can transmit without being absorbed. Examples of the other molded article include textiles such as clothing.

As the first step, a material for the part to which recesses and protrusions are desired to be transferred is prepared. As the second step, the molding die 10 is pressed against the part desired to be transferred. At that time, by irradiating the material with light, heat, or the like, flowability is imparted thereto. This allows for transfer of the pattern with recesses and protrusions to the surface of the material. As the third step, the molding die 10 is released.

In the second step, it is preferable to irradiate the transfer surface of the molding die 10 with neutral particle beams so that it becomes highly water repellent. This is to etch the impurities and oxygen that are inevitably present on the surface of the pattern portion 12 of the molding die 10. The water repellency of the pattern portion 12, preferably high water repellency, is maintained and the releasing treatment in the third step is facilitated. By going through a series of processes described above, a molded article having a pattern with recesses and protrusions can be manufactured.

### (Application of molding die)

In the aforementioned method of manufacturing a molding die, a case may be assumed where the dimensions of the molding die are small and the dimensions of the molding die are smaller than the target surface of the molded article. To deal with such a case, multiple molding dies can be arranged on a two-dimensional basis.

### Second Embodiment

In the second embodiment, a lens will be described. The lens of the present embodiment includes a base portion and a pattern portion having recesses and protrusions provided on the surface of the base portion, and the pattern portion has a distance between centers of protruding portions of 15 to 50 nm.

### (Lens)

Fig. 1 is a schematic drawing of a lens according to the second embodiment of the present invention, and Fig. 1A is a cross-sectional view and Fig. 1B is a plan view. A lens 10 according to the second embodiment of the present invention includes a base portion 11 and a pattern portion 12 having recesses and protrusions provided on the surface of the base portion 11. Protruding portions in the pattern portion 12 are composed of pillars 13, for example.

It is preferable that the height H of the pillars 13 (that is, the height of the protruding portions) from the bottom surface 12A of the base portion 11 is 2 nm or more. The height H of the pillars 13 can be determined by, for example, analyzing a cross-sectional SEM image of the surface of the lens.

The distance L between pillars 13 (the shortest distance between protruding portions, that is, the shortest distance between the end portion of one protruding portion and the end portion of another protruding portion closest to that protruding portion) is preferably 5 nm or more, more preferably 15 nm or more, and further preferably 30 nm or more. In addition, the distance L between pillars 13 is preferably 40 nm or less, and is more preferably 30 nm or less. When the distance L between pillars 13 is in this range, a lens having water repellency can be obtained. The distance L between pillars 13 can be determined by analyzing a plan SEM image of the surface of the lens.

The distance between centers of protruding portions is 15 to 50 nm. The ratio of recessed and protruding portion (protrusion/distance between centers of protruding portions) in the pattern portion is preferably 0.5 or less, more preferably 0.4 or less, and further preferably 0.3 or less. When the ratio of recessed and protruding portion is in this range, a lens having water repellency can be obtained. The distance between centers of protruding portions can be determined by analyzing a plan SEM image of the surface of the lens. The ratio of recessed and protruding portion in the pattern portion refers to a ratio of (average width of protruding portions) / (average distance between centers of protruding portions). The average value of the width of protruding portions and the average value of the distance between centers of protruding portions can be determined by analyzing a plan SEM image of the surface of the lens.

The defect density in the pattern portion is preferably 10 × 10¹⁰ cm² or less, and is further preferably at or below the measurement limit and defect-free. Examples of making the defect density at or below 10 × 10¹⁰ cm² include a method of etching using a neutral particle beam apparatus. Measurement of the defect density is by the electron spin resonance method.

In the second embodiment of the present invention, it is preferable that the side 13A and the surface 13B of the pillars 13, and the bottom surface 12A between adjacent pillars 13, constituting the recesses and protrusions of the pattern portion 12, do not have an oxide layer. For example, the residual oxygen atoms can be removed from the surface by radical treatment with NF₃, hydrogen gas, and the like using a neutral particle beam apparatus, followed by annealing treatment. By removing oxygen atoms from the surface, the reduction in water repellency over time can be prevented.

In the second embodiment of the present invention, the degree of water repellency of the pattern portion 12 can be controlled by controlling the distance L between pillars 13, which are protruding portions in the pattern portion 12.

In the second embodiment of the present invention, it is further preferable that the side 13A and the surface 13B of the pillars 13, and the bottom surface 12A between pillars 13, constituting the pattern portion 12, is flat at the atomic level. The surface area of the pillar 13 and the bottom surface 12A would change, and thus the degree of water repellency of the lens 10 would change. The smaller the surface area of the pillar 13 and the bottom surface 12A, the better the water repellency is.

### (Method of manufacturing lens)

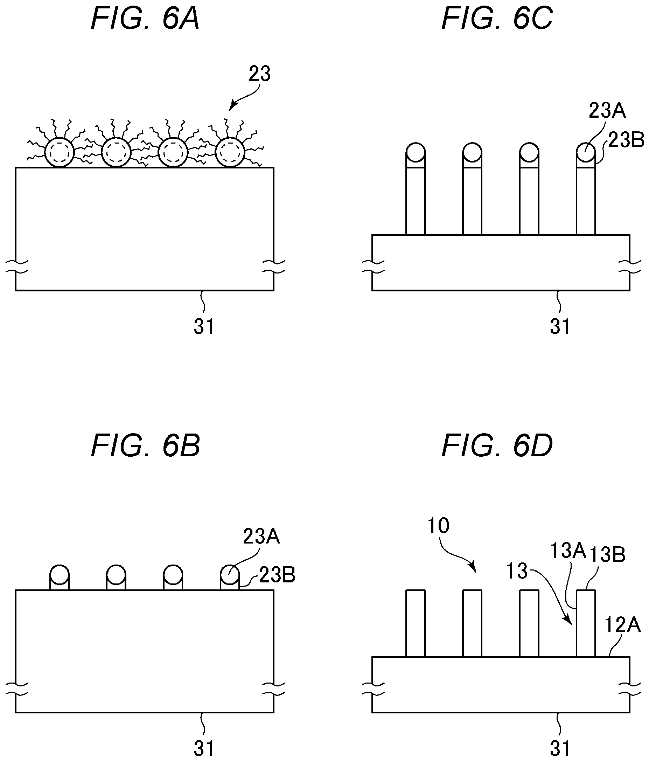

Figs. 6A to 6D are schematic drawings illustrating a method of manufacturing the lens 10 shown in Figs. 1A and 1B. A lens base 31 that will serve as the main body of a lens is prepared. The lens base 31 is mainly composed of SiO₂. First, impurities present on the surface of the lens base 31 are removed. The method of removal can be selected from various techniques conventionally known.

Next, as illustrated in Fig. 6A, a core-shell structure 23 is uniformly adsorbed onto the lens base 31. Due to the hydrophobic interaction of the shell of the core-shell structure 23, the core-shell structure 23 can be uniformly adsorbed onto the lens base 31 on a plane parallel to the lens base 31. The core-shell structure 23 is a structure with a core of a compound such as a metal or an oxide thereof and a shell of a protein, and examples of the core-shell structure include ferritin. As the core-shell structure 23, it is also possible to utilize a structure in which the outer circumference of a protein is modified with a polymer. Examples of the polymer include polyalkylene glycol such as polyethylene glycol and polypropylene glycol. By adjusting the molecular weight of the polymer (for example, adjusting the degree of polymerization of polyethylene glycol), the interval between cores can be controlled, and the distance between centers of protruding portions can be controlled. When the interval between cores is desired to be narrower, only ferritin is used as the core-shell structure without polymer modification.

Next, as illustrated in Fig. 6B, the polymer and the shell are removed by heat treatment or ozone treatment to expose the core metal or metal oxide. At this time, among the core-shell structure 23, a remaining portion 23B of the shell 23 may remain between the core 23A and the lens base 31. The temperature of the heat treatment is preferably 400°C or higher. The time of the heat treatment is preferably 5 minutes or longer. The time of the heat treatment is preferably 30 minutes or shorter.

As illustrated in Fig. 6C, the surface of the lens base 31 is etched using the core 23A as a mask. By adjusting the depth of this etching, the height H of the pillars 13 can be controlled. For the etching of the lens base 31, it is preferable to use a neutral particle beam processing apparatus (Patent Literature 3). In the neutral particle beam processing apparatus, it is preferable to use, for example, chlorine gas as the etching gas and to irradiate the substrate with neutral particle beams at 10 eV or more and 100 eV or less. By irradiating the lens 21 with neutral particle beams, it can be etched with low or no defects.

Then, the core 23A and the remaining portion 23B are removed. Examples of the method of removing the core 23A include a method in which wet etching with a dilute hydrochloric acid solution is performed for 30 minutes or longer.

### Examples

Next, Examples will be described in detail.

### (Example 1)

A molding die was made in the following manner. A Si substrate was prepared and placed in vacuum to remove the natural oxide film. An oxide film was formed on the Si substrate by a neutral particle beam processing apparatus (see Patent Literature 2). With respect to the conditions at that time, the substrate was irradiated with oxygen neutral particle beams having an energy of about 10 eV to form an oxide film of SiO₂. Next, a protein ferritin encapsulating iron oxide modified with polyethylene glycol with a molecular weight of 2000 was placed on the oxide film. With this molecular weight polyethylene glycol, the distance between iron oxides was 25 nm. Then, the polyethylene glycol and protein were removed by subjecting the substrate with ferritin placed thereon to heat treatment at 400°C for 30 minutes under an oxygen atmosphere, and the core, iron oxide, was exposed. Subsequently, the surface of the Si substrate was exposed by removing the oxide film by radical treatment with NF₃ and hydrogen gas using a radical treatment apparatus, and furthermore, the Si substrate was etched by 90 nm with chlorine neutral particle beams of about 10 eV using a neutral particle beam processing apparatus. As such, multiple pillars with a height of 90 nm were formed so that the distance between the pillars was 25 nm. Next, the surface of the substrate was subjected to wet etching using a dilute hydrochloric acid solution (water:HCl = 5:5) for 30 minutes. In Example 1, the substrate was further treated with radicals using NF₃ and hydrogen gas at room temperature for 15 minutes, followed by annealing at 150°C for 15 minutes in hydrogen gas. Doing this completely removed the remaining SiO₂ film from the surface. Onto the surface of the molding die made in this way, 0.002 cm³ (2 µl) of a water droplet was dropped, and the contact angle of the water droplet to the surface with a pattern of recesses and protrusions was measured to be 98 degrees. The surface of the molding die was measured by an electron spin resonance apparatus, and the defect density was 10 × 10¹⁰ cm² or less. The width of protruding portions was 10 nm, the distance between centers of protruding portions was 25 nm, and the ratio of recessed and protruding portion (protrusion/distance between centers of protruding portions) was 0.40.

Using the molding die obtained in Example 1, a molded article was manufactured. Although the molding die of Example 1 was not provided with a release layer and no release agent was used during molding, the molded article could be released from the molding die without any problems.

### (Reference Example 1)

In Reference Example 1, with multiple pillars having a height of 90 nm formed with a distance of 25 nm therebetween as in Example 1, 0.002 cm³ (2 µl) of a water droplet was dropped onto the surface of the molding die prior to the treatment with radicals using NF₃ and hydrogen gas, and the wettability of the surface with the pattern of recesses and protrusions was confirmed to be super hydrophilic.

### (Example 2)

In Example 2, a molding die was obtained in the same manner as in Example 1, except that the Si substrate was etched by 45 nm with a neutral particle beam processing apparatus and multiple pillars having a height of 45 nm were formed at a distance of 25 nm therebetween. Onto the surface of the molding die thus made, 0.002 cm³ (2 µl) of a water droplet was dropped, and the contact angle of the water droplet to the surface with a pattern of recesses and protrusions was measured to be 115 degrees. The surface of the molding die was measured by an electron spin resonance apparatus, and the defect density was 10 × 10¹⁰ cm² or less. The width of protruding portions was 10 nm, the distance between centers of protruding portions was 25 nm, and the ratio of recessed and protruding portion (protrusion/distance between centers of protruding portions) was 0.40.

### (Reference Example 2)

In Reference Example 2, with multiple pillars having a height of 45 nm formed with a distance of 25 nm therebetween as in Example 2, 0.002 cm³ (2 µl) of a water droplet was dropped onto the surface of the molding die prior to the treatment with radicals using NF₃ and hydrogen gas, and the wettability of the surface with the pattern of recesses and protrusions was confirmed to be super hydrophilic.

### (Example 3)

In Example 3, a molding die was obtained in the same manner as in Example 1, except that the Si substrate was etched by 24 nm with a neutral particle beam processing apparatus and multiple pillars having a height of 24 nm were formed at a distance of 25 nm therebetween. Onto the surface of the molding die thus made, 0.002 cm³ (2 µl) of a water droplet was dropped, and the contact angle of the water droplet to the surface with a pattern of recesses and protrusions was measured to be 100 degrees. The surface of the molding die was measured by an electron spin resonance apparatus, and the defect density was 10 × 10¹⁰ cm² or less. The width of protruding portions was 10 nm, the distance between centers of protruding portions was 25 nm, and the ratio of recessed and protruding portion (protrusion/distance between centers of protruding portions) was 0.40.

### (Reference Example 3)

In Reference Example 3, with multiple pillars having a height of 24 nm formed with a distance of 25 nm therebetween as in Example 3, 0.002 cm³ (2 µl) of a water droplet was dropped onto the surface of the molding die prior to the treatment with radicals using NF₃ and hydrogen gas, and the contact angle of the water droplet to the surface with the pattern of recesses and protrusions was measured to be 5 degrees.

### (Example 4)

In Example 4, through the same process as in Example 1, an oxide film was formed on the Si substrate by a neutral particle beam processing apparatus. Without modification with polyethylene glycol, a protein ferritin encapsulating iron oxide was placed on the oxide film. The distance between iron oxides was 5 nm. The protein was removed by heat treatment at 400°C under an oxygen atmosphere, and the core, iron oxide, was exposed. Subsequently, the oxide film was removed using a neutral particle beam processing apparatus and then the surface of the Si substrate was exposed with a reverse pattern, and furthermore, the Si substrate was etched by 24 nm with a neutral particle beam processing apparatus. As such, multiple pillars with a height of 24 nm were formed at a distance of 5 nm therebetween. In Example 4, the substrate was further treated with radicals using NF₃ and hydrogen gas for 15 minutes, followed by annealing at 150°C for 15 minutes in hydrogen gas. Doing this completely removed the remaining oxygen atoms from the surface. Onto the surface of the molding die made in this way, 0.002 cm³ (2 µl) of a water droplet was dropped, and the contact angle of the water droplet to the surface with a pattern of recesses and protrusions was measured to be 112 degrees. The surface of the molding die was measured by an electron spin resonance apparatus, and the defect density was 10 × 10¹⁰ cm² or less. The width of protruding portions was 7 nm, the distance between centers of protruding portions was 15 nm, and the ratio of recessed and protruding portion (protrusion/distance between centers of protruding portions) was 0.47.

### (Reference Example 4)

In Reference Example 4, with multiple pillars having a height of 24 nm formed with a distance of 5 nm therebetween as in Example 4, 0.002 cm³ (2 µl) of a water droplet was dropped onto the surface of the molding die prior to the treatment with radicals using NF₃ and hydrogen gas, and the contact angle of the water droplet to the surface with the pattern of recesses and protrusions was measured to be 9 degrees.

### (Example 5)

In Example 5, through the same process as in Example 1, multiple pillars with a height of 90 nm were formed at a distance of 25 nm therebetween. In Example 5, the substrate was further treated with radicals using NF₃ and hydrogen gas for 30 minutes, followed by annealing at 100°C for 15 minutes in hydrogen gas. Doing this completely removed the remaining oxygen atoms from the surface. Onto the surface of the molding die made in this way, 0.002 cm³ (2 µl) of a water droplet was dropped, and the contact angle of the water droplet to the surface with a pattern of recesses and protrusions was measured to be 95 degrees. The surface of the molding die was measured by an electron spin resonance apparatus, and the defect density was 10 × 10¹⁰ cm² or less. The width of protruding portions was 10 nm, the distance between centers of protruding portions was 25 nm, and the ratio of recessed and protruding portion (protrusion/distance between centers of protruding portions) was 0.40.

### (Example 6)

In Example 6, through the same process as in Example 2, multiple pillars with a height of 45 nm were formed at a distance of 25 nm therebetween. In Example 6, the substrate was further treated with radicals using NF₃ and hydrogen gas for 30 minutes, followed by annealing at 150°C for 15 minutes in hydrogen gas. Doing this completely removed the remaining oxygen atoms from the surface. Onto the surface of the molding die made in this way, 1 cm³ (1 ml) of a water droplet was dropped, and the contact angle of the water droplet to the surface with a pattern of recesses and protrusions was measured to be 104 degrees. The surface of the molding die was measured by an electron spin resonance apparatus, and the defect density was 10 × 10¹⁰ cm² or less. The width of protruding portions was 10 nm, the distance between centers of protruding portions was 25 nm, and the ratio of recessed and protruding portion (protrusion/distance between centers of protruding portions) was 0.40.

### (Example 7)

In Example 7, through the same process as in Example 3, multiple pillars with a height of 24 nm were formed at a distance of 25 nm therebetween. In Example 7, the substrate was further treated with radicals using NF₃ and hydrogen gas for 30 minutes, followed by annealing at 150°C for 15 minutes in hydrogen gas. Doing this completely removed the remaining oxygen atoms from the surface. Onto the surface of the molding die made in this way, 0.002 cm³ (2 µl) of a water droplet was dropped, and the contact angle of the water droplet to the surface with a pattern of recesses and protrusions was measured to be 97 degrees. The surface of the molding die was measured by an electron spin resonance apparatus, and the defect density was 10 × 10¹⁰ cm² or less. The width of protruding portions was 10 nm, the distance between centers of protruding portions was 15 nm, and the ratio of recessed and protruding portion (protrusion/distance between centers of protruding portions) was 0.40.

### (Example 8)

In Example 8, through the same process as in Example 4, multiple pillars with a height of 24 nm were formed at a distance of 5 nm therebetween. In Example 8, the substrate was further treated with radicals using NF₃ and hydrogen gas for 30 minutes, followed by annealing at 150°C for 15 minutes in hydrogen gas. Doing this completely removed the remaining oxygen atoms from the surface. Onto the surface of the molding die made in this way, 0.002 cm³ (2 µl) of a water droplet was dropped, and the contact angle of the water droplet to the surface with a pattern of recesses and protrusions was measured to be 110 degrees. The surface of the molding die was measured by an electron spin resonance apparatus, and the defect density was 10 × 10¹⁰ cm² or less. The width of protruding portions was 10 nm, the distance between centers of protruding portions was 25 nm, and the ratio of recessed and protruding portion (protrusion/distance between centers of protruding portions) was 0.40.

### (Reference Examples 5 to 8)

In each of Reference Examples 1 to 4, multiple pillars having a predetermined height were formed with a predetermined distance therebetween, the oxygen atoms on the surface was removed by performing HF treatment for 1 minute and 30 seconds without treatment with radicals using NF₃ and hydrogen gas, and 0.002 cm³ (2 µl) of a water droplet was dropped onto the surface to measure the contact angle of the water droplet to the surface with a pattern of recesses and protrusions. The contact angle of the water droplet to the surface with a pattern of recesses and protrusions on which multiple pillars having a height of 90 nm were formed with a distance of 25 nm therebetween was 61 degrees (Reference Example 5); the contact angle of the water droplet to the surface with a pattern of recesses and protrusions on which multiple pillars having a height of 45 nm were formed with a distance of 25 nm therebetween was 111 degrees (Reference Example 6); the contact angle of the water droplet to the surface with a pattern of recesses and protrusions on which multiple pillars having a height of 24 nm were formed with a distance of 25 nm therebetween was 112 degrees (Reference Example 7); and the contact angle of the water droplet to the surface with a pattern of recesses and protrusions on which multiple pillars having a height of 25 nm were formed with a distance of 5 nm therebetween was 104 degrees (Reference Example 8).

### (Reference Examples 9 to 11)

In the Si substrate used in Examples 1 to 4, when the natural oxide film was attached, the contact angle with a water droplet was 48 degrees (Reference Example 9), and when the HF treatment was performed for 1 minute and 30 seconds to remove the oxygen molecules, the contact angle with a water droplet was 90 degrees (Reference Example 10). In addition, the Si substrate used in Examples 1 to 4 was treated with radicals using NF₃ and hydrogen gas for 30 minutes to remove the natural oxide film, followed by annealing at 150°C for 15 minutes in hydrogen gas. Doing this completely removed the remaining oxygen atoms from the surface. 0.002 cm³ (2 µl) of a water droplet was dropped, and the contact angle of the water droplet to the surface with the pattern of recesses and protrusions was measured to be 97 degrees (Reference Example 11).

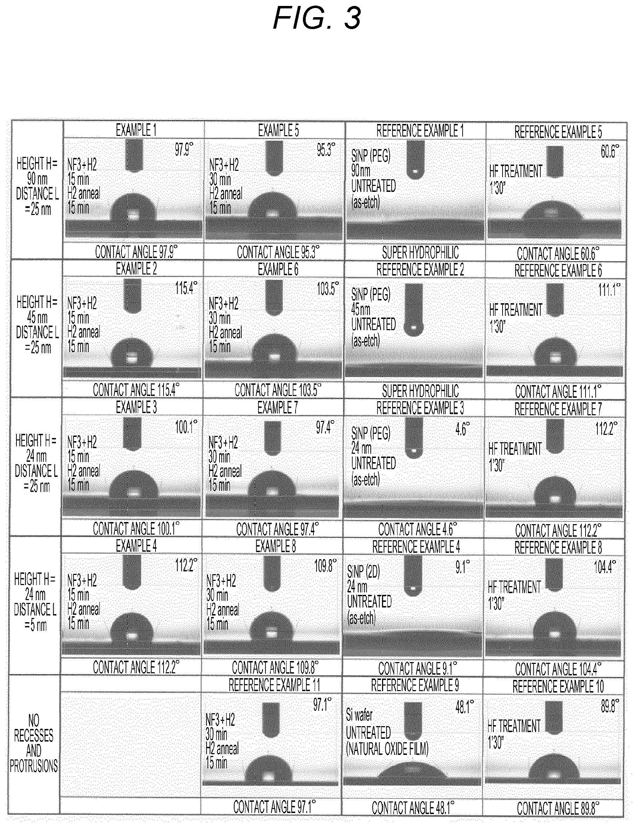

Fig. 3 is a table summarizing the results for Examples, Comparative Examples, and Reference Examples. From this table, the following was found.

Comparing Reference Examples 5 to 8 with Reference Example 9, by providing nano-sized recesses and protrusions on the surface of the molding die, the degree of hydrophilicity of the surface is increased. However, when further compared with Examples 1 to 4, by removing the oxygen atoms on the surface of the pattern of recesses and protrusions, the molding die can be adjusted to have water repellency, and even high water repellency. In the case of a constant interval between pillars, the degree of water repellency can be made higher when the height of pillars is 1.5 or more and 3 or less times the distance between pillars.

Comparing each of Examples 1 to 4 and each of Examples 5 to 8, the degree of water repellency decreases, albeit slightly, as the etching time with the neutral particle beam is extended. This is because when the aspect ratio (height H/distance L) becomes too large, capillarity becomes stronger and water repellency is reduced.

Comparing Examples 1 to 8 with Reference Examples 5 to 8, it can be seen that surface treatment with a neutral particle beam processing machine is more effective than HF treatment in providing water repellency as the aspect ratio (height H/distance L) increases. Comparing Reference Examples 5 to 8 with Reference Example 11, it can be seen that HF treatment is effective in making the recessed and protruding structure have water repellency.

Note that, although the processing by neutral particle beams is used in Examples and the HF treatment is used in Reference Example, this is just for the sake of clarity of explanation. Embodiments of the present invention do not presuppose processing with neutral particle beams.

As Examples of the invention, in addition to the above, structures of Si pillars with a height of 25 nm to 100 nm, a distance of 10 to 25 nm, a pillar diameter of 14 nm, and a density of 1 to 7 × 10¹¹/cm² were made by neutral particle beams etching. It was found that the surface wettability can be controlled from being super hydrophilic to highly water repellent, depending on the presence or absence of the surface treatment with neutral particle beams.

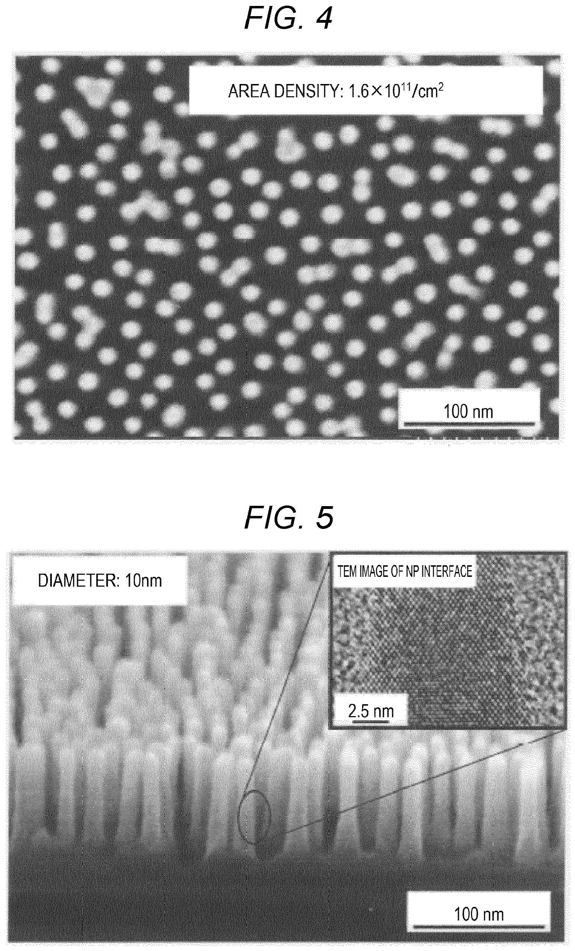

Fig. 4 is a plan SEM image of a structure with silicon nanopillars made by the same procedure as in the Examples of the present invention. Fig. 5 is a cross-sectional SEM image and TEM image of a silicon nanopillar (NP) structure. In this silicon nanopillar structure, the area density was 1.6 × 10¹¹/cm², the distance between centers of silicon nanopillars was 25 nm (standard deviation σ = 2 nm), and the diameter of silicon nanopillars was 10 nm. From the interface TEM image of the nanopillars, it was found that they are flat and have no defects at the atomic layer level.

From the Examples of the present invention, it was found that effective molded articles can be made with molding dies with low or no defects.

### (Example 9)

A lens of the present invention was made in the following manner. A lens mainly composed of SiO₂ (a flat lens with a thickness of 0.525 mm) was prepared. Next, a protein ferritin encapsulating iron oxide was placed on the surface of the lens. Then, the protein was removed by subjecting the lens with ferritin placed thereon to heat treatment at 400°C for 30 minutes under an oxygen atmosphere, and the core, iron oxide, was exposed. Thereafter, the lens was etched by 3 nm using a neutral particle beam processing apparatus at 10 eV with Cl₂ as the etching gas under the conditions of 0.1 Pa and -20 °C. As such, multiple pillars with a distance therebetween of 12 nm and a height of 3 nm were formed. Next, the surface of the lens was subjected to wet etching using a dilute hydrochloric acid solution (water:HCl = 5:5) for 15 minutes twice. Onto the surface of the lens made in this way, 0.002 cm³ (2 µl) of a water droplet was dropped, and the contact angle of the water droplet to the surface with a pattern of recesses and protrusions was measured to be 95 degrees. The surface of the lens was measured by an electron spin resonance apparatus, and the defect density was 10 × 10¹⁰ cm² or less. The width of protruding portions was 7 nm, the distance between centers of protruding portions was 15 nm, and the ratio of recessed and protruding portion (protrusion/distance between centers of protruding portions) was 0.47.

### (Example 10)

A lens of the present invention was made in the same manner as in Example 9, except that ferritin modified with polyethylene glycol with a molecular weight of 2000 was used instead of ferritin. The distance between pillars was 25 nm and the height of pillars was 3 nm. In addition, onto the surface of the lens thus made, 0.002 cm³ (2 µl) of a water droplet was dropped, and the contact angle of the water droplet to the surface with a pattern of recesses and protrusions was measured to be 100 degrees. The surface of the molding die was measured by an electron spin resonance apparatus, and the defect density was 10 × 10¹⁰ cm² or less. The width of protruding portions was 10 nm, the distance between centers of protruding portions was 25 nm, and the ratio of recessed and protruding portion (protrusion/distance between centers of protruding portions) was 0.40.

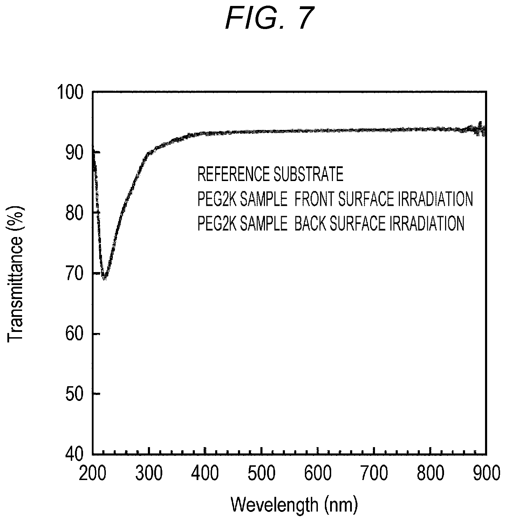

For the lens obtained in Example 10, the transmittance at 200 to 900 nm was measured. The transmittance was measured for the case where transmission light was emitted perpendicularly to the front surface from the side on which the recessed and protruding portion was provided (front surface side), for the case where transmission light was emitted perpendicularly to the back surface from the back surface side opposite to the front surface on which the recessed and protruding portion was provided, and for the lens before providing the recessed and protruding portion that was used to manufacture the lens of Example 10. For the measurement of transmittance, a UV-Vis-NIR apparatus (manufactured by JASCO Corporation, trade name: V-670DS) was used. The measured results are shown in Fig. 7. From Fig. 7, in all cases, there was no change in the transmittance and no adverse effects such as a decrease in transmittance due to the provision of recesses and protrusions on the surface of the lens were observed.

### (Example 11)

A lens of the present invention was made in the same manner as in Example 9, except that ferritin modified with polyethylene glycol with a molecular weight of 10000 was used instead of ferritin. The distance between pillars was 40 nm and the height of pillars was 3 nm. In addition, onto the surface of the lens thus made, 0.002 cm³ (2 µl) of a water droplet was dropped, and the contact angle of the water droplet to the surface with a pattern of recesses and protrusions was measured to be 105 degrees. The surface of the molding die was measured by an electron spin resonance apparatus, and the defect density was 10 × 10¹⁰ cm² or less. The width of protruding portions was 10 nm, the distance between centers of protruding portions was 40 nm, and the ratio of recessed and protruding portion (protrusion/distance between centers of protruding portions) was 0.25.

### (Comparative Example 1)

A lens of the present invention was made in the same manner as in Example 9, except that ferritin modified with polyethylene glycol with a molecular weight of 20000 was used instead of ferritin. The distance between pillars was 60 nm and the height of pillars was 3 nm. In addition, onto the surface of the lens thus made, 0.002 cm³ (2 µl) of a water droplet was dropped, and the contact angle of the water droplet to the surface with a pattern of recesses and protrusions was measured to be 55 degrees. The surface of the molding die was measured by an electron spin resonance apparatus, and the defect density was 10 × 10¹⁰ cm² or less. The width of protruding portions was 10 nm, the distance between centers of protruding portions was 60 nm, and the ratio of recessed and protruding portion (protrusion/distance between centers of protruding portions) was 0.16.

### [Reference Signs List]

- 10: MOLDING DIE, LENS
- 11: BASE PORTION
- 12: PATTERN PORTION
- 12A: BOTTOM SURFACE
- 13: PILLARS
- 13A: SIDE OF PILLAR
- 13B: SURFACE OF PILLAR
- 21: SUBSTRATE
- 22: FILM
- 22A: REMAINING PORTION OF FILM
- 23: CORE-SHELL STRUCTURE
- 23A: CORE
- 23B: REMAINING PORTION OF SHELL
- 31: LENS BASE

## Claims

1. A molding die comprising:
a base portion; and
a pattern portion having recesses and protrusions provided on a surface of the base portion, wherein
a distance between the centers of protruding portions of the pattern portion is 15 to 50 nm,
a ratio of recessed and protruding portion (protrusion/distance between centers of the protruding portions) of the pattern portion is 0.5 or less,
a height of the protruding portion of the pattern portion is 2 nm or more, and
a defect density of the pattern portion is 10 × 10¹⁰ cm² or less.

2. The molding die according to claim 1, wherein the surface of the pattern portion does not have a layer consisting of an oxide.

3. The molding die according to claim 1 or 2, wherein the base portion and the pattern portion are composed of the same material.

4. The molding die according to any one of claims 1 to 3, wherein a ratio of (height of the protruding portion) / (distance between centers of the protruding portions) of the pattern portion is 0.4 to 10.

5. A method of manufacturing a molded article, comprising transferring the recesses and protrusions of the pattern portion, using the molding die according to any one of claims 1 to 4.

6. A lens comprising:
a base portion; and
a pattern portion having recesses and protrusions provided on a surface of the base portion, wherein
a distance between centers of protruding portions of the pattern portion is 15 to 50 nm.

7. The lens according to claim 6, wherein the shortest distance between the protruding portions of the pattern portion is 5 nm.

8. The lens according to claim 6 or 7, wherein a defect density of the pattern portion is 10 × 10¹⁰ cm² or less.

9. The lens according to any one of claims 6 to 8, wherein the surface of the pattern portion does not have a layer consisting of an oxide.

10. A method of manufacturing an article including a base portion and a pattern portion having recesses and protrusions provided on a surface of the base portion, the article having a distance between centers of protruding portions of the pattern portion of 15 to 50 nm, the method comprising:
adsorbing uniformly a core-shell structure modified with a polymer onto a surface of the base portion or a surface of a layer provided on the base portion;
removing a shell of the core-shell structure; and
etching the base portion, using a core of the core-shell structure as a mask.
